# EUROPEAN PATENT SPECIFICATION

(11) **EP 0 663 139 B1**
(45) Date of publication and mention of the grant of the patent: **12.07.2000**
(21) Application number: 93923758.2
(22) Date of filing: 30.09.1993
(51) Int. Cl.: H05B 41/16, H05B 41/24, H01J 7/46, H01J 11/04, H01J 11/00, H01J 17/20, H01J 1/02, H01J 65/04

(54) **ELECTRODELESS LAMP WITH BULB ROTATION**
ELEKTRODENLOSE LAMPE MIT DREHENDER BIRNE
LAMPE SANS ELECTRODES A AMPOULE TOURNANTE

(30) Priority: 30.09.1992 US 953056; 18.11.1992 US 976938; 16.04.1993 US 46671; 16.04.1993 US 47090
(43) Date of publication of application: 19.07.1995
(60) Divisional application: 99102738.4
(73) Proprietor: FUSION LIGHTING, INC., Rockville, MD 20855 (US)
(72) Inventor: DOLAN, James, T., Frederick, MD 21702 (US); WOOD, Charles, H., Rockville, MD 20853 (US); KAMAREHI, Mohammed, N. Potomac, MD 20878 (US); SIMPSON, James, E., Gaithersburg, MD 20880 (US); TURNER, Brian, Myersville, MD 21773 (US); PREMYSLER, Philip, A., Rockville, MD 20853 (US); Ury, Michael G., Rockville, Maryland 20855 (US)
(74) Representative: Schwepfinger, Karl-Heinz, Dipl.-Ing.
(86) International application number: US9309373
(87) International publication number: WO9408439

(56) References cited:
- US-A- 3 942 058
- US-A- 4 485 332
- US-A- 4 507 587
- US-A- 4 887 192
- US-A- 4 954 756

## Description

The invention relates to an electrodeless lamp as defined in the pre-characterizing part of claim 1.

Discharge lamps and particularly electrodeless discharge lamps which contain a condensable fill are known. When the lamp is not operating and cold, the condensable portion of the fill is condensed on the inside of the lamp envelope. These lamps usually also contain a gas which remains gaseous even at low temperatures. This gas facilitates starting as will be described below, and it may also serve the purpose of affecting the performance of the plasma by changing the thermal conductivity of the plasma.

Capacitively coupled, inductively coupled, and microwave excited varieties of electrodeless lamps are known. All of these lamp have in common that the power is supplied to the lamps, not through electrodes which penetrate the bulb, but rather by being subject to an externally produced electromagnetic oscillation. The variation of the pattern of the electromagnetic field, depends on the structure and operation of the external source of the electromagnetic field. Generally there are some areas of the bulb which are subject to higher electromagnetic field, at least during start up.

The starting process of discharge lamps with condensable fill and starting gas has several stages. At first the electromagnetic field is applied, then some minute ionization occurs in the bulb, perhaps by the incidence of a gamma ray from outer space, or as a result of photoelectrons being emitted from the envelope or condensed fill by the action of irradiation from an auxiliary source of ultraviolet light, or by some other agency. The electromagnetic field energizes the electrons and an avalanche breakdown occurs which leads to ionization of the whole starting gas (to some extent e.g. first or second ionization) to form a plasma therefrom. This initial plasma will be relatively low power density and may have a variation in intensity over the interior of the bulb that is different from that of the steady state plasma. The starting gas plasma heats the bulb envelope and thereby causes the evaporation of the condensable fill which is in turn ionized to partake of the discharge. As the condensable fill evaporates, the discharge becomes higher power until all the fill is vaporized and the power reaches its steady state value. The change in power absorbed by the bulb changes, because the impedance of the bulb changes as the condensable fill evaporates and the pressure in the bulb increases.

Upon turning off the power to the lamp, the condensable fill condenses in the area of the interior of the lamp which cools off fastest. This portion may be the area subject to the most forced external cooling e.g. under the cooling air jet, or the area which runs coolest at full power operation.

As discussed above, the starting gas plasma has some variation in intensity over the interior of the bulb. If the starting gas plasma is not very intense in the area of the bulb where the condensable fill condenses it takes a long time to evaporate the condensable fill and thus start the bulb. It may even be impossible, and even if it can be done the interval varies from one start up to the next, i.e., it is not repeatable.

Linear microwave electrodeless lamp made by the assignee of the instant invention direct cooling air and radiate microwave power toward the bulb from the same side. Thus, upon turning off the power, the fill condenses on the side of the bulb which receives power upon restarting the lamp.

According to the present invention, an electrodeless lamp envelope is provided with walls of reduced thickness at the area of the envelope wall where it is desired to condense the fill upon turning off the power. Such thinner wall portions by virtue of their higher thermal conductance between the inner and outer surfaces and their lower heat capacity (lower thermal mass) cool down faster.

The electrodeless lamp may subject the lamp envelope to external forced cooling and the lamp envelope may be arranged to have thinner walls at the area of the envelope wall where it is desired to condense the fill upon turning off the power.

According to a preferred embodiment of an aspect of the invention, a spherical electrodeless lamp envelope has a variation in wall thickness as a function of elevation angle i.e. from the equator to the poles, with a minimum in wall thickness at the equator. The same is subject to an electromagnetic field which is most intense near the equator, and to radially directed cooling air.

According to a further embodiment, an elongated envelope electrodeless lamp excited in a TM110 cavity which is supposed to subject the envelope to an relatively uniform field has a segment of its axial length which has a thinner wall positioned near a coupling slot of the cavity so as to receive strong direct radiation therefrom upon start up. Thus, an electrodeless lamp is provided which starts quickly and assuredly.

The invention will be better understood by referring to the accompanying drawings, wherein:
Figure 1 shows an embodiment of the invention.
Figure 2 is a cross-sectional view of a lamp according to a further embodiment of the invention.
Figure 3 is a schematic illustration of a still further embodiment of the invention. .
Figure 4 is a detailed cross-sectional view of the bulb according to the embodiment of Figure 3.

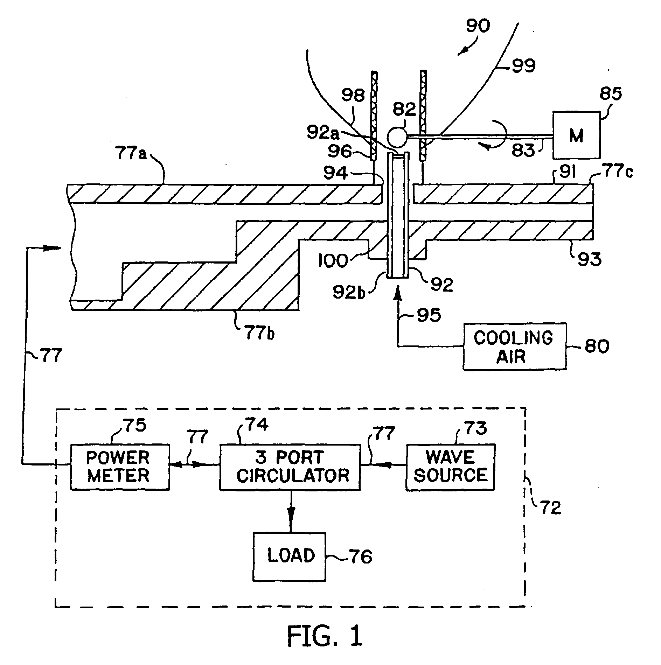

Referring to Figures 1, a preferred embodiment of the invention will be described. The lamp fixture generally designated by 90 is fed power from an experimental set up power system generally designated by reference numeral 72.

The power system is configured as follows. A microwave or radio frequency (r.f.) source 73 generates power. The power density applied to the bulb is preferably from about a few hundred to about 10,000 watts per cubic centimeter of bulb volume.

The source 73 is coupled to a three port circulator 74 which isolates the source 73 from non-absorbed power that is reflected from the fixture 90. The circulator is connected to a power meter 75 which measures forward and reflected power and a dissipative load 76 which absorbs reflected power. Power flows through the power meter 75 to the section of waveguide 77a which is connected to the fixture. All connection lines designated by reference numerals 77, 77a represent rectangular waveguide. The dissipative load 76 is connected directly to the circulator 74. In a finalized production design, the power system 72 may be considerably simplified by eliminating the power meter 75, circulator 74, and dissipative load 76, once the design is fixed and finally tuned.

The waveguide section 77a is connected to a stepped section 77b which comprises two steps in the height of the waveguide connected to low height section of waveguide 77c. The steps serve as an impedance transformer to partially match the impedance of the waveguide 77, 77a to that of the fixture 90 which is mounted on the top broadside 91 of the low height waveguide section 77c. The inner conductor 92 is mounted on the lower broad wall 93 of the reduced height waveguide section 77c, and extends upwards through a hole 94 in the upper broad wall 91. The inner conductor is fixed by set screw 100. The hole in the upper broad wall 91 is large enough to provide insulating gap clearance. The top 92a of the inner conductor 92 is located below the end of the bulb. In the embodiment shown, the top of the inner conductor 92 is recessed. Cooling air is fed from source 80 through line 95 to the bottom of the inner conductor 92 at the lower broad wall 93, through a bore 92b up the length of the inner conductor 92b to one or more cooling air jet orifices in the base of recess 92a and is jetted against the bulb 82. Preferably the cooling holes (not shown) comprise two holes of 0.9 mm arranged along the equator of the bulb and two holes of 0.5 mm arranged near the respective poles of the bulb. (The bulb stem 83 abuts the bulb at one pole). All the holes are arranged on a circle 3.0 mm diameter centered below the bulb. The outer conductor comprises an open cylindrical wall 96 connected to the upper broad wall 91. It is taller than the inner conductor. Although in the experimental model even with top of the outer conductor 96 open there is little leakage, the top may be capped with a suitably shaped end piece such as a flat piece or a spherical piece. The cylindrical wall 96, which may be at least partially foraminous or mesh-like, can serve as the outer conductor while at the same time being substantially transparent to the radiation of the lamp. Located around the bulb outside the outer conductor 96 is a metal reflector 99. The inner conductor 92 and the outer conductor 96 form a coaxial excitation structure, which produces high strength electromagnetic fields necessary for coupling to small, high power electrodeless discharge lamps.

The stem of the bulb 82 extends through a hole in the mesh 96 and a hole in the reflector 99 to a motor 85 to which it is mechanically coupled, which serves to rotate the bulb about an axis through the stem during operation.

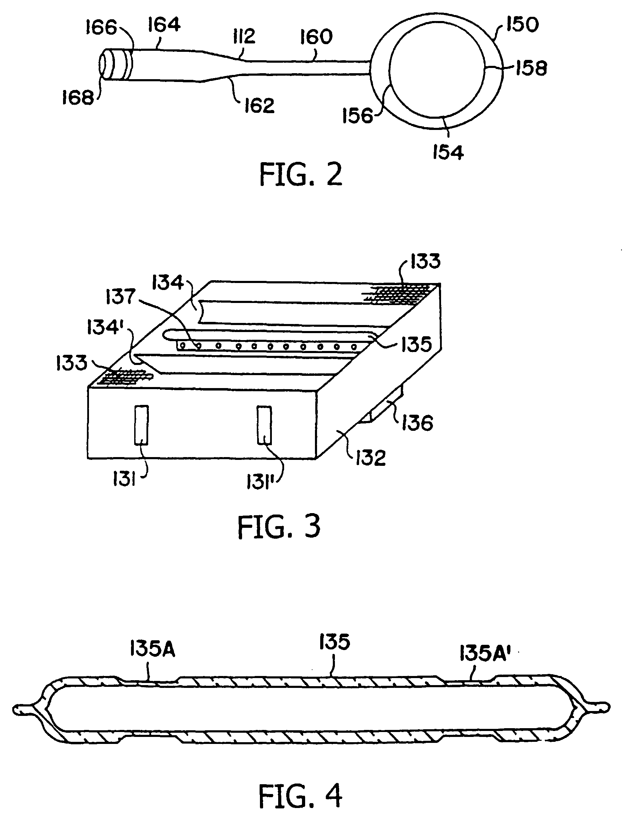

Referring to Figure 2, a further embodiment of the invention will be described. The lamp fixture generally designated by 20 is fed power from an experimental set up power system generally designated by reference numeral 2.

Referring to Figure 2, a cross-sectional view of the lamp bulb is shown. The bulb comprises a discharge envelope 150 and a stem 112, which lies along the polar axis of the bulb. The inside wall surface of the envelope is about 5 mm average diameter. In a 60 degree band 154, 30 degrees above the equator and 30 degrees below, the bulb wall thickness is maintained at 0.5 mm within a tolerance of ± 0.05 mm. The equator is taken with respect to the axis of the stem 112 as being the polar axis. The wall thickness at the poles 156 and 158 is maintained at 0.6 mm within the same tolerance. The wall thickness between the 60 degree equatorial band 154 and the poles gradually tapers between the two specified thicknesses.

When the power is turned off, the fill condenses on the thinner wall equatorial band 154.

The stem includes a 1.5 mm diameter section 160 which extends about 23 mm from the bulb. A tapered section 162 connected thereto about 5 mm in length and a final section 164, 4 mm in diameter, and about 25 mm in length. The final section is secured to the rotation motor. The final section includes a groove 166 for securing the bulb to a motor shaft (not shown) of the motor and chamfered section 168 which facilitates assembly of the bulb and motor.

According to the invention, the bulb fill comprises a condensable material in quantities relative to its vapor pressure such that a portion of the material will be condensed when the lamp is cold. By way of non-limitative example, the fill may comprise fills including but not limited to mercury with or without metal halide additives or metal oxyhalides, or sulfur containing fills. The fill may also comprise a material which is gaseous when the lamp is cold, including but not limited to neon, argon, krypton, or xenon or mixtures thereof. Such a gas may be included in amounts ranging from less than 1 to several hundreds of torr, preferably 1 to 1000 torr (measured at room temperature), more typically from about 20 to about 200 torr. In the preferred embodiment of the invention, the fill is a sulfur containing fill. By way of non-limitative example, The fill may be comprised of elemental sulfur or sulfur compounds including InS, As₂S₃, S₂Cl₂, Cs₂, In₂S₃ or SeS. The fill may be present at a pressure of between about 1 and 20 atmospheres at operating temperature, and may be excited at a power density of at least about 50 watts/cc. For example, the bulb shown and described in connection with Figures 1 and 2 may contain about .3 mg of sulfur and 150 torr of argon.

During the starting gas discharge phase of operation, as described in the background section, the discharge is concentrated near the equator and on the side of the equator near the end of the inner coaxial conductor. When the excitation energy is tuned off the condensable fill condenses on equatorial band 154 of the discharge bulb envelope. Upon starting the lamp, the condensable fill condensed on the equatorial band is quickly evaporated by the heating action of the starting gas discharge which occurs near the equator.

Referring to Figure 3, a further embodiment of the invention is shown. Microwave power is coupled through a pair of coupling slots 131, 131' from waveguides (not shown) into a hexahedron cavity 132 and supports a TH110 mode electromagnetic mode therein. There is also a component of the electromagnetic field which is not accounted for by the TM110 mode but is in the form of a radiation from the slots 131, 131'. The entire top of the cavity 132 is a screen 133 which allows light to exit the cavity. Inside the cavity are located a pair of interference reflector coated dielectric half reflectors 134, 134'. An elongated electrodeless discharge bulb 135 is located between the reflector halves 134, 134'. The discharge fill may comprise a fill of mercury, metal halide additives, and starting gas, a wide range of such fills being well known in the art. Cooling air is supplied by cooling air plenum through cooling air holes 137 to the bulb 135. Cooling holes 137 are in the bottom of the cavity and air is directed upwardly towards the bulb. The cooling is uniform over the length of the bulb.

Referring to Figure 4, a detailed cross-sectional view of the elongated discharge bulb, 135 is shown. The discharge bulb has two sections of reduced wall thickness 135A, 135A'. These two sections are located closest to coupling slots 131, 131' in the installed position.

When the power is turned off, the fill will condense at the sections of reduced wall thickness 135A, 135A'. Since these sections are near the coupling slots, they will be subject to high strength electromagnetic fields upon powering up the lamp and thereby starting will be facilitated.

## Claims

1. An electrodeless lamp, comprising:
a bulb (135; 150) having a bulb wall which encloses a fill which includes a fill portion which is condensable when power to the lamp is turned off,
means (77, 132) external to said bulb (135, 150) for coupling microwave or R.F. power thereto characterized in that
said bulb wall is of reduced thickness (135A, 135A', 154) in a particular region or regions, and in that
said power coupling means (77, 132) being such that when the lamp is turned on said power is distributed, at least during a lamp starting phase, in said bulb (135, 150) so as to be higher in said particular region or regions.

2. The electrodeless lamp of claim 1, wherein said bulb wall is made of quartz.

3. The electrodeless lamp of claim 1 or 2, wherein said fill also includes a starting gas, which forms a discharge during said lamp starting phase.

4. The electrodeless lamp of any of claims 1 to 3, wherein said bulb (150) is substantially spherical in shape, said means (77, 132) external to said bulb for coupling comprises coaxial excitation means having outer (96) and inner (92) conductors, and the bulb wall is of reduced thickness in a region which lies near said inner conductor (92) during lamp operation.

5. The electrodeless lamp of claim 4, wherein the region of reduced thickness is an equatorial region (154), further comprising means (85) for rotating the bulb about an axis through its poles.

6. The electrodeless lamp of any of claims 1 to 5, wherein said fill comprises a sulfur based fill.

7. The electrodeless lamp of claim 1, further characterized
in that, said means for coupling comprises a TM110 hexahedron cavity (132), provided with one or more coupling slots (131, 131'), and
said bulb (135) is tubular in shape, and has a bulb wall of reduced thickness at a region or respective regions (135A, 135A') which are located near said coupling slot or respective slots (131, 131').

8. The electrodeless lamp of claim 1, wherein said means for coupling microwave or R.F. power is closer to said particular region or regions ((154; 135A, 135A') of said bulb (150; 135) than to the remainder of said bulb.

## Patentansprüche

1. Elektrodenlose Lampe, mit:
einem Kolben (135; 150), der eine Kolbenwand besitzt, die einen Füllstoft einschließt, der einen Füllstoffanteil enthält, der kondensierbar ist, wenn die Leistungszufuhr an die Lampe unterbrochen wird,
Mitteln (77, 132) außerhalb des Kolbens (135, 150), die Mikrowellen- oder HF-Leistung in diesen einkoppeln, dadurch gekennzeichnet, daß
die Kolbenwand in einem oder mehreren besonderen Bereichen eine reduzierte Dicke (135A, 135A', 154) aufweist und daß
die Leistungseinkopplungsmittel (77, 132) so beschaffen sind, daß beim Einschalten der Lampe die Leistung wenigstens während der Lampenstartphase im Kolben (135, 150) so verteilt wird, daß sie in dem oder den besonderen Bereichen höher ist.

2. Elektrodenlose Lampe nach Anspruch 1, wobei die Kolbenwand aus Quarz hergestellt ist.

3. Elektrodenlose Lampe nach Anspruch 1 oder 2, wobei der Füllstoff außerdem ein Startgas enthält, das während der Lainpenstartphase eine Entladung bildet.

4. Elektrodenlose Lampe nach einem der Ansprüche 1 bis 3, wobei der Kolben (150) eine im wesentlichen sphärische Form hat, wobei die Einkopplungsmittel (77, 132) außerhalb des Kolbens koaxiale Erregungsmittel mit äußeren (96) und inneren (92) Leitern aufweisen und wobei die Kolbenwand in einem Bereich, der während des Betriebs der Lampe in der Nähe des inneren Leiters (92) liegt, eine reduzierte Dicke besitzt.

5. Elektrodenlose Lampe nach Anspruch 4, wobei der Bereich mit reduzierter Dicke ein Äquatorialbereich (154) ist, ferner mit Mitteln (85) zum Drehen des Kolbens um eine durch seine Pole verlaufende Achse.

6. Elektrodenlose Lampe nach einem der Ansprüche 1 bis 5, wobei der Füllstoff einen Füllstoff auf Schwefelbasis enthält.

7. Elektrodenlose Lampe nach Anspruch 1, ferner dadurch gekennzeichnet, daß
die Einkopplungsmittel einen TM110-Hexahedron-Hohlraum (132) aufweisen, der mit einem oder mehreren Einkopplungsschlitzen (131, 131') versehen ist, und
der Kolben (135) röhrenförmig ist und in einem oder in entsprechenden Bereichen (135A, 135A'), die sich in der Nähe des oder der jeweiligen Einkopplungsschlitze (131, 131') befinden, eine Kolbenwand mit reduzierter Dicke besitzt.

8. Elektrodenlose Lampe nach Anspruch 1, wobei sich die Mittel zum Einkoppeln von Mikrowellen- oder HF-Leistung näher an dem oder den besonderen Bereichen (154; 135A, 135A') des Kolbens (150; 135) als am übrigen Kolben befinden.

## Revendications

1. Lampe sans électrode, comprenant:
une ampoule (135; 150) avec une paroi d'ampoule entourant un remplissage comprenant une partie de remplissage condensable quand l'énergie apportée à la lampe est coupée,
un moyen (77, 132) extérieur à ladite ampoule pour coupler une énergie hypertréquence ou une énergie radiofréquence à ce dernier, caractérisée en ce que
ladite paroi d'ampoule est d'épaisseur réduite (135A, 135A', 154) dans une ou des régions déterminées, et en ce que
ledit moyen de couplage d'énergie (77, 132) est tel que quand la lampe est allumée, ladite énergie est distribuée dans ladite ampoule (135,150), au moins durant une phase de démarrage de la lampe, de sorte qu'elle soit supérieure dans la ou lesdites régions déterminées.

2. Lampe sans électrode selon la revendication 1, dans laquelle ladite paroi d'ampoule est en quartz.

3. Lampe sans électrode selon la revendication 1 ou 2, dans laquelle le remplissage comprend également un gaz de démarrage qui produit une décharge durant ladite phase de démarrage de la lampe.

4. Lampe sans électrode selon l'une quelconque des revendications 1 à 3, dans laquelle ladite amppoule (150) est sensiblement de forme sphérique, lesdits moyens (77, 132) extérieurs à ladite ampoule pour couplage comprenant un moyen d'excitation coaxial ayant des conducteurs externes (96) ou internes (92), et la paroi d'ampoule étant d'épaisseur réduite dans une région proche du conducteur interne (92) durant le fonctionnement de la lampe.

5. Lampe sans électrode selon la revendication 4, dans laquelle la région d'épaisseur réduite est une région équatoriale (154), comprenant en outre un moyen (85) pour faire pivoter l'ampoule autour d'un axe passant par ses pôles.

6. Lampe sans électrode selon l'une quelconque des revendications 1 à 5, dans laquelle le remplissage comprend un remplissage à base de sulfure.

7. Lampe sans électrode selon la revendication 1, caractérisée en outre en ce que,
ledit moyen de couplage comprend une cavité (132) hexahèdre TM110, pourvue d'une ou plusieurs fentes de couplage (131, 131'), et
ladite ampoule (135) est de forme tubulaire, et elle a une paroi d'ampoule d'épaisseur réduite dans une région ou des régions respectives (135A, 135A') qui se trouvent près de ladite fente ou des fentes respectives (131, 131') de couplage.

8. Lampe sans électrode selon la revendication 1, dans lequel ledit moyen de couplage de l'énergie hyperfréquence ou de l'énergie radiofréqence est plus proche de la ou desdites régions déterminées (154; 135A, 135A') de ladite ampoule (150; 135) que du reste de ladite ampoule.
